# EUROPEAN PATENT APPLICATION

(11) **EP 4 746 030 A1**
(43) Date of publication of application: **20.05.2026**
(21) Application number: 24853649.2
(22) Date of filing: 08.08.2024
(51) Int. Cl.: H01L 21/67, H01L 21/687

(54) **TEMPERATURE CONTROL APPARATUS AND METHOD, AND SEMICONDUCTOR PROCESSING DEVICE**

(30) Priority: 16.08.2023 CN 202311035663
(71) Applicant: Beijing NAURA Microelectronics Equipment Co., Ltd., Beijing 100176 (CN)
(72) Inventor: LE, Zhongtian, Beijing 100176 (CN); FAN, Guanghua, Beijing 100176 (CN); ZHU, Wanyu, Beijing 100176 (CN); GUO, Heng, Beijing 100176 (CN); SHAN, Lutong, Beijing 100176 (CN)
(74) Representative: Cohausz & Florack
(86) International application number: PCT/CN2024/110635
(87) International publication number: WO 2025/036239

(57) **Abstract**

The present application provides a temperature control device, a temperature control method, and semiconductor process equipment. In the temperature control device, a first supply unit is configured to provide a fluid at a first temperature; a second supply unit is configured to provide a fluid at a second temperature; and a fluid pump is connected to an output end of a fluid channel. A fluid control unit is configured to deliver the fluid provided by the first supply unit and/or the fluid provided by the second supply unit and/or the fluid output by the fluid pump to the fluid channel, to detect in real time a first temperature value of the fluid output to an input end of the fluid channel, and to adjust in real time, according to the first temperature value and a preset target temperature value, a flow ratio of the first supply unit and/or the second supply unit and/or the fluid pump delivering fluid to the fluid channel, such that the first temperature value is equal to the target temperature value. The present solution can improve both the heating rate and the cooling rate of an electrostatic chuck.

## Description

### TECHNICAL FIELD

The present application relates to the field of semiconductor manufacturing, and more particularly, to a temperature control device, a method, and semiconductor process equipment.

### BACKGROUND

Currently, the wafer temperature control function of semiconductor process equipment is achieved through the combined action of a cooling unit and a heating unit in an electrostatic chuck. The cooling unit generally uses a refrigerant at a predetermined temperature flowing in a cooling pipeline to remove heat, thereby cooling the wafer. The heating element generates heat when supplied with electrical current, thereby heating the wafer.

Often, if it is necessary to increase the wafer temperature, the power supplied to the heating element must be increased. If it is necessary to decrease the wafer temperature, operation of the heating element must be stopped, and heat is removed by the refrigerant flowing in the cooling unit to cool the wafer. The temperature and flow rate of the refrigerant determine the heat dissipation rate of the cooling unit. As such, in order to shorten process execution time and improve throughput, both the heating rate and the cooling rate of the electrostatic chuck must be increased.

However, increasing the heating rate necessarily requires increasing the power supplied to the heating element. This not only increases the design difficulty of the electrostatic chuck, but also requires larger filtering components to accommodate the higher heating power. The filtering components further increase the space occupied by the equipment. Meanwhile, the cooling unit cannot dynamically adjust the flow rate and temperature of the refrigerant flowing therein. That is, the temperature and flow rate of the refrigerant entering the cooling unit remain constant and cannot be adjusted in real time. The cooling efficiency can only be improved, prior to the refrigerant entering the cooling unit, by increasing its temperature or reducing its flow rate. However, since the refrigerant continuously flows into the cooling unit at all times, more heat generated by the heating element during operation is removed by the refrigerant, thereby significantly reducing the heating rate. Accordingly, the existing temperature control devices cannot simultaneously improve both the heating rate and the cooling rate of the electrostatic chuck.

### SUMMARY

The present application aims to solve at least one of the technical problems existing in the prior art by providing a temperature control device, a method, and semiconductor process equipment, which can improve both the heating rate and the cooling rate of a controlled component.

To achieve the above objective, a temperature control device is provided. The temperature control device is applied to semiconductor process equipment and comprises:
a first supply unit configured to provide a fluid at a first temperature;
a second supply unit configured to provide a fluid at a second temperature, wherein the second temperature is higher than the first temperature;
a fluid pump connected to an output end of a fluid channel in a controlled component of the semiconductor process equipment and configured to extract fluid from the fluid channel; and
a fluid control unit connected to the first supply unit, the second supply unit, the fluid pump, and an input end of the fluid channel. The fluid control unit is configured to deliver the fluid provided by the first supply unit, and/or the fluid provided by the second supply unit, and/or the fluid output by the fluid pump, to the fluid channel. The fluid control unit is further configured to detect, in real time, a first temperature value of the fluid output from the fluid control unit to the input end of the fluid channel, and to adjust, in real time, a flow ratio of the first supply unit and/or the second supply unit and/or the fluid pump delivering fluid to the fluid channel according to the first temperature value and a preset target temperature value, such that the first temperature value is equal to the target temperature value.

In some embodiments, the fluid control unit is configured to switch among a cooling mode, a heating mode, and a constant temperature mode.

In the cooling mode, the fluid control unit is configured to split and deliver the fluid provided by the first supply unit to the fluid channel and to the first supply unit, and to split and deliver the fluid output by the fluid pump to the first supply unit and to the input end of the fluid channel.

In the heating mode, the fluid control unit is configured to split and deliver the fluid provided by the second supply unit to the fluid channel and to the second supply unit, and to split and deliver the fluid output by the fluid pump to the second supply unit and to the input end of the fluid channel.

In the constant temperature mode, the fluid control unit is configured to split and deliver the fluid provided by the first supply unit to the fluid channel and to the first supply unit, to split and deliver the fluid provided by the second supply unit to the fluid channel and to the second supply unit, and to split and deliver the fluid output by the fluid pump to the first supply unit, the second supply unit, and the input end of the fluid channel.

In some embodiments, in the constant temperature mode, the fluid control unit is further configured, when the fluid stored in the first supply unit is lower than a first liquid level, to split and deliver the fluid output by the fluid pump to the first supply unit and to the input end of the fluid channel; or, when the fluid stored in the second supply unit is lower than a second liquid level, to split and deliver the fluid output by the fluid pump to the second supply unit and to the input end of the fluid channel.

In some embodiments, in the constant temperature mode, the fluid control unit is further configured, prior to switching to the cooling mode, to split and deliver the fluid output by the fluid pump to the first supply unit and to the input end of the fluid channel; or, prior to switching to the heating mode, to split and deliver the fluid output by the fluid pump to the second supply unit and to the input end of the fluid channel.

In some embodiments, the fluid control unit comprises:
a first temperature sensor configured to detect the first temperature value in real time; and
a first control unit configured to enter the cooling mode when an absolute value of a difference between the first temperature value and the target temperature value is greater than or equal to a preset temperature threshold and the target temperature value is less than the first temperature value; to enter the heating mode when the absolute value is greater than or equal to the preset temperature threshold and the target temperature value is greater than the first temperature value; or to enter the constant temperature mode when the absolute value is less than the preset temperature threshold.

In some embodiments, the fluid control unit further comprises:
a second temperature sensor configured to detect, in real time, a second temperature value at an output end of the first supply unit;
a third temperature sensor configured to detect, in real time, a third temperature value at an output end of the second supply unit;
a fourth temperature sensor configured to detect, in real time, a fourth temperature value at an output end of the fluid pump;
wherein the first control unit is further configured, based on the first temperature value, the second temperature value, the third temperature value, the fourth temperature value, and the target temperature value, to adjust in real time, in the cooling mode, a flow ratio of the first supply unit and the fluid pump delivering fluid to the fluid channel; or, in the heating mode, to adjust in real time a flow ratio of the second supply unit and the fluid pump delivering fluid to the fluid channel; or, in the constant temperature mode, to adjust in real time a flow ratio of the first supply unit, the second supply unit, and the fluid pump delivering fluid to the fluid channel.

In some embodiments, the fluid control unit further comprises:
a flow detection unit configured to detect, in real time, a detected flow value at the input end of the fluid channel; and
a second control unit configured, when the detected flow value exceeds a preset flow range, to control a pumping speed of the fluid pump until the detected flow value falls within the preset flow range.

In some embodiments, the fluid control unit comprises:
a first supply flow path, one end of which is connected to the output end of the first supply unit and another end of which is connected to the input end of the fluid channel, wherein a first flow regulating valve and a first on-off valve are disposed on the first supply flow path;
a second supply flow path, one end of which is connected to the output end of the second supply unit and another end of which is connected to the input end of the fluid channel, wherein a second flow regulating valve and a second on-off valve are disposed on the second supply flow path;
a third supply flow path, one end of which is connected to the output end of the fluid pump and another end of which is connected to the input end of the fluid channel, wherein a third flow regulating valve is disposed on the third supply flow path;
a first return flow path, one end of which is connected to the output end of the first supply unit and another end of which is connected to the input end of the first supply unit, wherein a fourth flow regulating valve is disposed on the first return flow path;
a second return flow path, one end of which is connected to the output end of the second supply unit and another end of which is connected to the input end of the second supply unit, wherein a fifth flow regulating valve is disposed on the second return flow path; and
a third return flow path, a first return branch, and a second return branch, wherein one end of the third return flow path is connected to the output end of the fluid pump, and another end thereof is respectively connected to one end of the first return branch and one end of the second return branch; a sixth flow regulating valve is disposed on the third return flow path; another end of the first return branch and another end of the second return branch are respectively connected to the input end of the first supply unit and the input end of the second supply unit; and a third on-off valve and a fourth on-off valve are respectively disposed on the first return branch and the second return branch.

In some embodiments, the fluid control unit further comprises a first mixing part, a second mixing part, and a third mixing part, wherein:
the first mixing part has one output end and three input ends, and the output end of the first mixing part is connected to the input end of the fluid channel; the other end of the first supply flow path, the other end of the second supply flow path, and the other end of the third supply flow path are respectively connected to the three input ends of the first mixing part;
the other end of the first return branch is connected to the first return flow path downstream of the fourth flow regulating valve; the second mixing part is disposed on the first return flow path and is located at a connection between the first return flow path and the other end of the first return branch;
the other end of the second return branch is connected to the second return flow path downstream of the fifth flow regulating valve; the third mixing part is disposed on the second return flow path and is located at a connection between the second return flow path and the other end of the second return branch.

In some embodiments, a seventh regulating valve is disposed on the first return flow path between the second mixing part and the input end of the first supply unit; and an eighth regulating valve is disposed on the second return flow path between the third mixing part and the input end of the second supply unit.

Another aspect of the present application provides a temperature control method applied to the temperature control device described above, the method comprising:
delivering the fluid provided by the first supply unit, and/or the fluid provided by the second supply unit, and/or the fluid output by the fluid pump to the fluid channel, and detecting in real time a first temperature value of the fluid output to the input end of the fluid channel; and
adjusting in real time, according to the first temperature value and a preset target temperature value, a flow ratio of the first supply unit and/or the second supply unit and/or the fluid pump delivering fluid to the fluid channel, such that the first temperature value is equal to the target temperature value.

In some embodiments, the fluid control unit further comprises a first liquid mixing part, a second liquid mixing part, and a third liquid mixing part, wherein:
the first liquid mixing part has one output end and three input ends, and the output end of the first liquid mixing part is connected to the input end of the fluid channel; the other end of the first supply flow path, the other end of the second supply flow path, and the other end of the third supply flow path are respectively connected to the three input ends of the first liquid mixing part;
the other end of the first return branch is connected to the first return flow path downstream of the fourth flow regulating valve; the second liquid mixing part is disposed on the first return flow path and is located at a connection between the first return flow path and the other end of the first return branch;
the other end of the second return branch is connected to the second return flow path downstream of the fifth flow regulating valve; the third liquid mixing part is disposed on the second return flow path and is located at a connection between the second return flow path and the other end of the second return branch.

In some embodiments, a seventh regulating valve is disposed on the first return flow path between the second liquid mixing part and the input end of the first supply unit; and an eighth regulating valve is disposed on the second return flow path between the third liquid mixing part and the input end of the second supply unit.

Another aspect of the present application provides a temperature control method applied to the temperature control device described above, the method comprising:
delivering the fluid provided by the first supply unit, and/or the fluid provided by the second supply unit, and/or the fluid output by the fluid pump to the fluid channel, and detecting in real time a first temperature value of the fluid output to the input end of the fluid channel; and
adjusting in real time, according to the first temperature value and a preset target temperature value, a flow ratio of the first supply unit and/or the second supply unit and/or the fluid pump delivering fluid to the fluid channel, such that the first temperature value is equal to the target temperature value.

In some embodiments, the adjusting in real time, according to the first temperature value and a preset target temperature value, a flow ratio of the first supply unit and/or the second supply unit and/or the fluid pump delivering fluid to the fluid channel, such that the first temperature value is equal to the target temperature value, comprises:
when an absolute value of a difference between the first temperature value and the target temperature value is greater than a preset temperature threshold, and the target temperature value is less than the first temperature value, entering a cooling mode; and in the cooling mode, splitting and delivering the fluid provided by the first supply unit to the fluid channel and to the first supply unit, and splitting and delivering the fluid output by the fluid pump to the first supply unit and to the input end of the fluid channel;
when the absolute value is greater than the preset temperature threshold, and the target temperature value is greater than the first temperature value, entering a heating mode; and in the heating mode, splitting and delivering the fluid provided by the second supply unit to the fluid channel and to the second supply unit, and splitting and delivering the fluid output by the fluid pump to the second supply unit and to the input end of the fluid channel;
and when the absolute value is less than or equal to the preset temperature threshold, entering a constant temperature mode; and in the constant temperature mode, splitting and delivering the fluid provided by the first supply unit to the fluid channel and to the first supply unit, splitting and delivering the fluid provided by the second supply unit to the fluid channel and to the second supply unit, and splitting and delivering the fluid output by the fluid pump to the first supply unit, the second supply unit, and the input end of the fluid channel.

In some embodiments, the method further comprises:
detecting, in real time, a detected flow value at the input end of the fluid channel; and
when the detected flow value exceeds a preset flow range, controlling a pumping speed of the fluid pump until the detected flow value falls within the preset flow range.

As another technical solution, the present application further provides semiconductor process equipment, comprising a process chamber and a pedestal disposed in the process chamber. The pedestal is configured to support a wafer. A fluid channel configured to control a temperature of the wafer is disposed in the pedestal. The semiconductor process equipment further comprises the temperature control device described above, configured to control a temperature of a fluid in the fluid channel.

The temperature control device and method provided in the present application deliver the fluid provided by the first supply unit, and/or the fluid provided by the second supply unit, and/or the fluid output by the fluid pump to the fluid channel, and detect in real time a first temperature value of the fluid output by the fluid control unit to the input end of the fluid channel. According to the first temperature value and a preset target temperature value, a flow ratio of the first supply unit and/or the second supply unit and/or the fluid pump delivering fluid to the fluid channel is adjusted in real time, thereby enabling real-time control of the temperature of the fluid supplied to the fluid channel of the controlled component.

Because the present solution heats or cools the controlled component through fluid in both heating and cooling processes, compared with conventional devices that use fluid for cooling and a heating element for heating, the present solution avoids the problem that heat generated by the heating element during operation is removed by refrigerant. As a result, both the heating rate and the cooling rate of the controlled component can be improved.

The semiconductor process equipment provided in the present application, by adopting the temperature control device described above, can improve both the heating rate and the cooling rate of the electrostatic chuck.

### BRIEF DESCRIPTION OF THE DRAWINGS

FIG. 1 is a schematic diagram of a temperature control device according to an embodiment of the present application;
FIG. 2 is a schematic diagram of another temperature control device according to an embodiment of the present application;
FIG. 3 is a schematic diagram illustrating two closed-loop controls employed in an embodiment of the present application;
FIG. 4 is a structural diagram of the temperature control device according to an embodiment of the present application;
FIG. 5 is a curve diagram showing a temperature at the output end of the first supply unit, a temperature at the output end of the second supply unit, and a temperature at the input end of the fluid channel;
FIG. 6A is a flowchart of a temperature control method according to an embodiment of the present application;
FIG. 6B is a flowchart illustrating specific steps of the temperature control method according to an embodiment of the present application; and
FIG. 7 is a flowchart of another temperature control method according to an embodiment of the present application.

### DETAILED DESCRIPTION OF THE EMBODIMENTS

To enable those skilled in the art to better understand the technical solutions of the present application, the temperature control device, method, and semiconductor process equipment provided by the present application are described in detail below with reference to the accompanying drawings.

The temperature control device provided in the embodiments of the present application is applied to semiconductor process equipment. Specifically, the temperature control device is configured to deliver a fluid, such as cooling liquid or cooling water, into a fluid channel of a controlled component in the semiconductor process equipment, and to recover fluid flowing out of the fluid channel, thereby achieving circulation of the fluid. During the circulation of the fluid, the temperature of the fluid flowing into the fluid channel is controlled to realize heating, cooling, and constant temperature control of the fluid.

The controlled component may, for example, be a chuck configured to support a wafer, such as an electrostatic chuck. The chuck is provided with the fluid channel described above. The fluid flowing in the fluid channel performs heat exchange with the chuck to indirectly control the temperature of the wafer, thereby satisfying process temperature requirements for the wafer. Of course, in practical applications, the controlled component may also be other components in the semiconductor process equipment that require temperature control. The embodiments of the present application are not particularly limited in this regard.

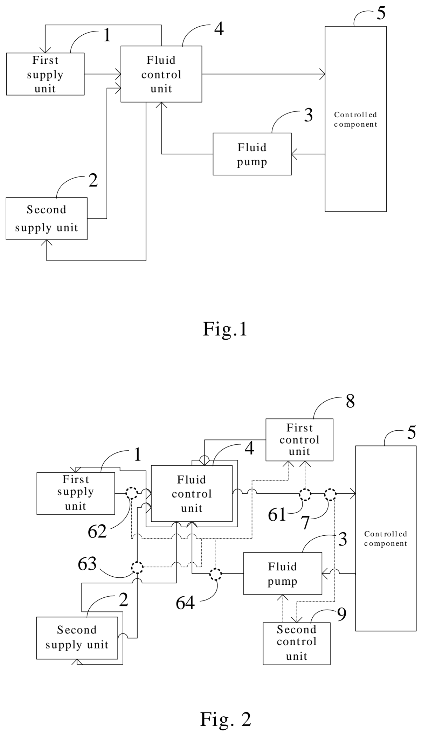

Specifically, referring to FIG. 1, the temperature control device provided in the embodiment of the present application comprises: a first supply unit 1, a second supply unit 2, a fluid pump 3, and a fluid control unit 4.

The first supply unit 1 is configured to provide a fluid at a first temperature. The second supply unit 2 is configured to provide a fluid at a second temperature. The first supply unit 1 and the second supply unit 2 may, for example, be chillers configured to store the fluid and equipped with a pressure source (such as a compressor) capable of driving the fluid to flow.

The second temperature is higher than the first temperature. That is, the first supply unit 1 is configured for cooling, and the second supply unit 2 is configured for heating. For example, the first temperature may be lower than 30°C, and the second temperature may be higher than 80°C. The first temperature and the second temperature respectively correspond to the temperatures of the fluids stored in the first supply unit 1 and the second supply unit 2.

The fluid pump 3 is connected to an output end of the fluid channel (not shown in the figure) in the controlled component 5, and is configured to extract fluid from the fluid channel. The fluid pump 3 provides a driving force for circulation of the fluid in the fluid channel. In some embodiments, a rotational speed of the fluid pump 3 is adjustable, such that a pumping speed of the fluid pump 3 can be adjusted, thereby enabling adjustment of a fluid flow rate at the input end of the fluid channel.

The fluid control unit 4 is connected to the first supply unit 1, the second supply unit 2, the fluid pump 3, and the input end of the fluid channel. The fluid control unit 4 is configured to deliver the fluid provided by the first supply unit 1, and/or the fluid provided by the second supply unit 2, and/or the fluid output by the fluid pump 3 to the fluid channel, and to detect in real time a first temperature value of the fluid output by the fluid control unit 4 to the input end of the fluid channel. According to the first temperature value and a preset target temperature value, the fluid control unit 4 adjusts in real time a flow ratio of the first supply unit 1 and/or the second supply unit 2 and/or the fluid pump 3 delivering fluid to the fluid channel, such that the first temperature value is equal to the target temperature value.

By delivering the fluid provided by the first supply unit 1, and/or the fluid provided by the second supply unit 2, and/or the fluid output by the fluid pump 3 to the fluid channel, and detecting in real time the first temperature value of the fluid output to the input end of the fluid channel, and adjusting in real time the flow ratio of the first supply unit 1, and/or the fluid provided by the second supply unit 2, and/or the fluid output by the fluid pump 3 according to the first temperature value and the preset target temperature value, the temperature of the fluid supplied to the fluid channel of the controlled component can be controlled in real time. Because the present solution heats and cools the controlled component using fluid in both heating and cooling processes, compared with conventional devices that use fluid for cooling and a heating element for heating, the present solution avoids the problem that heat generated by a heating element during operation is removed by refrigerant. As a result, both the heating rate and the cooling rate of the controlled component can be improved.

In some embodiments, the fluid control unit 4 is configured to switch among a cooling mode, a heating mode, and a constant temperature mode.

In the cooling mode, the fluid control unit 4 is configured to split and deliver the fluid provided by the first supply unit 1 to the fluid channel and to the first supply unit 1, and to split and deliver the fluid output by the fluid pump 3 to the first supply unit 1 and to the input end of the fluid channel. That is, the fluid provided by the first supply unit 1 may be entirely delivered to the fluid channel, entirely returned to the first supply unit 1, or partially delivered to the fluid channel and partially returned to the first supply unit 1. The fluid output by the fluid pump 3 may be entirely delivered to the first supply unit 1, entirely delivered to the input end of the fluid channel, or partially delivered to the first supply unit 1 and partially delivered to the input end of the fluid channel.

In the heating mode, the fluid control unit 4 is configured to split and deliver the fluid provided by the second supply unit 2 to the fluid channel and to the second supply unit 2, and to split and deliver the fluid output by the fluid pump 3 to the second supply unit 2 and to the input end of the fluid channel. Similar to the cooling mode described above, in the heating mode, the fluid provided by the second supply unit 2 may be entirely delivered to the fluid channel, entirely returned to the second supply unit 2, or partially delivered to the fluid channel and partially returned to the second supply unit 2. The fluid output by the fluid pump 3 may be entirely delivered to the second supply unit 2, entirely delivered to the input end of the fluid channel, or partially delivered to the second supply unit 2 and partially delivered to the input end of the fluid channel.

In the constant temperature mode, the fluid control unit 4 is configured to split and deliver the fluid provided by the first supply unit 1 to the fluid channel and to the first supply unit 1, to split and deliver the fluid provided by the second supply unit 2 to the fluid channel and to the second supply unit 2, and to split and deliver the fluid output by the fluid pump 3 to the first supply unit 1, the second supply unit 2, and the input end of the fluid channel.

In the constant temperature mode, the fluid provided by the first supply unit 1 may be entirely delivered to the fluid channel, or partially delivered to the fluid channel and partially returned to the first supply unit 1. The fluid provided by the second supply unit 2 may be entirely delivered to the fluid channel, or partially delivered to the fluid channel and partially returned to the second supply unit 2.

The fluid output by the fluid pump 3 may be entirely delivered to the first supply unit 1, entirely delivered to the second supply unit 2, or entirely delivered to the input end of the fluid channel. Alternatively, the fluid output by the fluid pump 3 may be partially delivered to the first supply unit 1 and partially delivered to the input end of the fluid channel; or partially delivered to the second supply unit 2 and partially delivered to the input end of the fluid channel; or partially delivered to the first supply unit 1, partially delivered to the second supply unit 2, and partially delivered to the input end of the fluid channel.

In some embodiments, in the cooling mode, a ratio of a flow rate of the fluid provided by the first supply unit 1 delivered to the fluid channel to a flow rate of the fluid returned to the first supply unit 1 is defined as a first flow ratio; and a ratio of a flow rate of the fluid output by the fluid pump 3 delivered to the first supply unit 1 to a flow rate of the fluid delivered to the input end of the fluid channel is defined as a second flow ratio.

In the heating mode, a ratio of a flow rate of the fluid provided by the second supply unit 2 delivered to the fluid channel to a flow rate of the fluid returned to the second supply unit 2 is defined as a third flow ratio; and a ratio of a flow rate of the fluid output by the fluid pump 3 delivered to the second supply unit 2 to a flow rate of the fluid delivered to the input end of the fluid channel is defined as a fourth flow ratio.

In the constant temperature mode, a ratio of a flow rate of the fluid provided by the first supply unit 1 delivered to the fluid channel to a flow rate of the fluid returned to the first supply unit 1 is defined as a fifth flow ratio; a ratio of a flow rate of the fluid provided by the second supply unit 2 delivered to the fluid channel to a flow rate of the fluid returned to the second supply unit 2 is defined as a sixth flow ratio; and a ratio among a flow rate of the fluid output by the fluid pump 3 delivered to the first supply unit 1, a flow rate delivered to the second supply unit 2, and a flow rate delivered to the input end of the fluid channel is defined as a seventh flow ratio.

Among the first flow ratio through the seventh flow ratio described above, the flow ratio corresponding to a current mode may be calculated based on at least one of: the temperature at the output end of the first supply unit 1, the temperature at the output end of the second supply unit 2, the temperature at the output end of the fluid pump 3, the temperature at the input end of the fluid channel, and the target temperature value. A corresponding closed-loop control algorithm (for example, a PID control algorithm) may be used to calculate the flow ratio corresponding to the current mode from among the first flow ratio through the seventh flow ratio, and the calculated flow ratio may be output to the fluid control unit 4. The fluid control unit 4 performs splitting of the fluid provided by the first supply unit 1 and/or the second supply unit 2 and the fluid output by the fluid pump 3 according to the calculated flow ratio, thereby controlling a flow rate of the fluid delivered to the fluid channel and a flow rate of the fluid returned to the first supply unit 1 and/or the second supply unit 2.

The temperature control device provided in the embodiments of the present application enables real-time control of the temperature of the fluid supplied to the fluid channel of the controlled component by switching the fluid control unit 4 among the cooling mode, the heating mode, and the constant temperature mode, thereby realizing heating, cooling, and constant temperature control of the fluid. Because both heating and cooling are achieved through fluid-based heat exchange with the controlled component, compared with conventional devices that use fluid for cooling and a heating element for heating, the present solution avoids the problem that heat generated by a heating element during operation is removed by refrigerant. As a result, both the heating rate and the cooling rate of the controlled component can be improved.

On this basis, in each of the cooling mode, the heating mode, and the constant temperature mode, the fluid control unit 4 may split the fluid provided by the first supply unit 1 and/or the second supply unit 2 and the fluid output by the fluid pump 3 according to a corresponding flow ratio, so as to control both the flow rate of the fluid delivered to the fluid channel and the flow rate of the fluid returned to the first supply unit 1 and/or the second supply unit 2.

Compared with a configuration in which only the output flow rate of the first supply unit 1 and/or the second supply unit 2 is controlled, the present solution not only enables, when the flow rate at the output end of the first supply unit 1 and/or the second supply unit 2 and the flow rate at the output end of the fluid pump 3 change, control of the flow rate returned to the first supply unit 1 and/or the second supply unit 2 so as to maintain constant flow resistance at the output end of the first supply unit 1 and/or the second supply unit 2 and at the output end of the fluid pump 3, thereby avoiding an adverse impact of pressure fluctuations on control accuracy; but also enables control of the flow rate returned to the first supply unit 1 and/or the second supply unit 2 so as to ensure that a liquid level of the fluid in the first supply unit 1 and/or the second supply unit 2 satisfies operational requirements, thereby avoiding a risk of insufficient liquid and ensuring stable operation of the equipment. In addition, the liquid reserve in the first supply unit 1 or the second supply unit 2 may be increased as needed to satisfy continuous temperature control requirements.

Because the structures between the first supply unit 1, the second supply unit 2, and the fluid pump 3 and the supply loop of the fluid channel, as well as the return loops returning to the first supply unit 1 and the second supply unit 2, cannot be completely identical, flow resistance in different flow paths may differ. As a result, even under identical driving pressure conditions of the first supply unit 1 and the second supply unit 2, flow rates in different flow paths may vary, which may cause the liquid levels of the fluids stored in the first supply unit 1 and the second supply unit 2 to become inconsistent after a period of operation. In severe cases, the liquid level in one of the supply units may become insufficient to maintain normal operation of the equipment.

To address this issue, in some embodiments, in the constant temperature mode, the fluid control unit 4 is further configured, when the fluid stored in the first supply unit 1 is lower than a first liquid level, to split and deliver the fluid output by the fluid pump 3 to the first supply unit 1 and to the input end of the fluid channel; or, when the fluid stored in the second supply unit 2 is lower than a second liquid level, to split and deliver the fluid output by the fluid pump 3 to the second supply unit 2 and to the input end of the fluid channel.

That is, in the constant temperature mode, if the liquid level of the fluid stored in the first supply unit 1 is too low, at least a portion of the fluid output by the fluid pump 3 is delivered only to the first supply unit 1 and not to the second supply unit 2, thereby increasing the flow rate delivered to the first supply unit 1. Similarly, if the liquid level of the fluid stored in the second supply unit 2 is too low, at least a portion of the fluid output by the fluid pump 3 is delivered only to the second supply unit 2 and not to the first supply unit 1, thereby increasing the flow rate delivered to the second supply unit 2. In this manner, the liquid level of the first supply unit 1 or the second supply unit 2 may be compensated, thereby maintaining normal operation of the equipment.

Because the temperature of the fluid output from the first supply unit 1 and the second supply unit 2 changes after participating in heat exchange, the following example is provided.

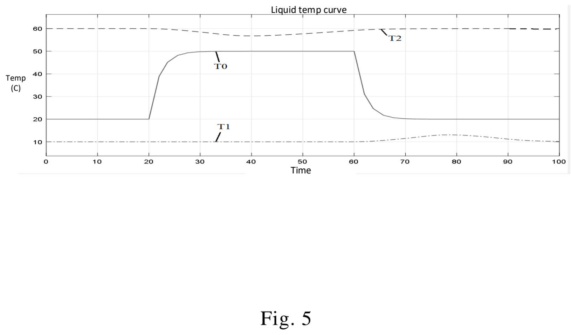

Let T0 denote the temperature at the input end of the fluid channel, T1 denote the temperature at the output end of the first supply unit 1, and T2 denote the temperature at the output end of the second supply unit 2. The curves corresponding to temperatures T0, T1, and T2 are shown in FIG. 5.

As illustrated in FIG. 5, the temperature T0 at the input end of the fluid channel increases from 20°C to 50°C and then decreases back to 20°C. During the heating process in which temperature T0 is adjusted to 50°C (beginning at 20 s), fluid stored in the second supply unit 2 is consumed. The output fluid, after flowing through the controlled component, decreases in temperature. When the temperature-reduced fluid returns to the second supply unit 2, it causes the temperature of the fluid stored in the second supply unit 2 to decrease, resulting in deviation of temperature T2 from the second temperature (which is 60°C in FIG. 5), thereby producing a downward fluctuation.

During the cooling process in which temperature T0 is adjusted to 20°C (beginning at 60 s), fluid stored in the first supply unit 1 is consumed. The output fluid, after flowing through the controlled component, increases in temperature. When the temperature-increased fluid returns to the first supply unit 1, it causes the temperature of the fluid stored in the first supply unit 1 to increase, resulting in deviation of temperature T1 from the first temperature (which is 10°C in FIG. 5), thereby producing an upward fluctuation.

FIG. 5 illustrates only a single heating and cooling cycle. If multiple such cycles are performed, the reserve of fluid in the first supply unit 1 and the second supply unit 2 that remains at substantially unchanged temperature will gradually be depleted. At that point, temperature T2 may significantly deviate from the second temperature, and temperature T1 may significantly deviate from the first temperature, making it impossible to continue effective heating or cooling control.

Therefore, in order to delay depletion of the reserve of fluid that remains at substantially unchanged temperature and to increase the number of continuous temperature-control operations (heating or cooling), it is necessary, prior to continuous temperature control, to increase the fluid reserve in the corresponding supply unit so as to reduce a rate of temperature change of the fluid output from the supply unit. Although temperature deviation may still occur, increasing the fluid reserve can increase the number of continuous temperature-control cycles and delay the onset of temperature fluctuations.

Based on the foregoing, in order to increase the fluid reserve of the corresponding supply unit prior to continuous temperature control, in some embodiments, in the constant temperature mode, the fluid control unit 4 is further configured, prior to switching to the cooling mode, to split and deliver the fluid output by the fluid pump 3 to the first supply unit 1 and to the input end of the fluid channel; or, prior to switching to the heating mode, to split and deliver the fluid output by the fluid pump 3 to the second supply unit 2 and to the input end of the fluid channel.

That is, when it is necessary to enter the cooling mode and perform continuous cooling, at least a portion of the fluid output by the fluid pump 3 may be delivered to the first supply unit 1 and not to the second supply unit 2, thereby increasing the fluid reserve delivered to the first supply unit 1. Similarly, when it is necessary to enter the heating mode and perform continuous heating, at least a portion of the fluid output by the fluid pump 3 may be delivered to the second supply unit 2 and not to the first supply unit 1, thereby increasing the fluid reserve delivered to the second supply unit 2.

In some embodiments, referring to FIG. 2, the fluid control unit 4 comprises a first temperature sensor 61 and a first control unit 8. The first temperature sensor 61 is configured to detect the first temperature value in real time. The first control unit 8 is configured to enter the cooling mode when an absolute value of a difference between the first temperature value and a preset target temperature value is greater than or equal to a preset temperature threshold and the target temperature value is less than the first temperature value; to enter the heating mode when the absolute value is greater than or equal to the preset temperature threshold and the target temperature value is greater than the first temperature value; or to enter the constant temperature mode when the absolute value is less than the preset temperature threshold.

Accordingly, automatic switching among the cooling mode, the heating mode, and the constant temperature mode may be achieved based on the first temperature value and the preset temperature threshold, thereby enabling automated control and improving temperature control accuracy.

Further, in some embodiments, continuing to refer to FIG. 2, the fluid control unit 4 further comprises a second temperature sensor 62, a third temperature sensor 63, and a fourth temperature sensor 64. The second temperature sensor 62 is configured to detect in real time a second temperature value at the output end of the first supply unit 1. The third temperature sensor 63 is configured to detect in real time a third temperature value at the output end of the second supply unit 2. The fourth temperature sensor 64 is configured to detect in real time a fourth temperature value at the output end of the fluid pump 3.

The first control unit 8 is further configured, based on the first temperature value, the second temperature value, the third temperature value, the fourth temperature value, and the target temperature value, to adjust in real time, in the cooling mode, a flow ratio of the first supply unit 1 and the fluid pump 3 delivering fluid to the fluid channel, that is, to adjust the first flow ratio and the second flow ratio; in the heating mode, to adjust in real time a flow ratio of the second supply unit 2 and the fluid pump 3 delivering fluid to the fluid channel, that is, to adjust the third flow ratio and the fourth flow ratio; or in the constant temperature mode, to adjust in real time a flow ratio of the first supply unit 1, the second supply unit 2, and the fluid pump 3 delivering fluid to the fluid channel, that is, to adjust the fifth flow ratio, the sixth flow ratio, and the seventh flow ratio.

In this manner, after entering a corresponding mode, the first control unit 8 may calculate, based on the first temperature value, the second temperature value, the third temperature value, the fourth temperature value, and the target temperature value, a flow ratio corresponding to the current mode using an appropriate closed-loop control algorithm (for example, a PID control algorithm), and adjust in real time the flow ratio of the first supply unit 1 and/or the second supply unit 2 and/or the fluid pump 3 delivering fluid to the fluid channel, such that the first temperature value is equal to the target temperature value, thereby achieving automated control and improving temperature control accuracy.

In some embodiments, continuing to refer to FIG. 2, in order to ensure that the flow rate of the fluid in the fluid channel remains stable, the fluid control unit 4 further comprises a flow detection unit 7 and a second control unit 9.

The flow detection unit 7 is configured to detect in real time a detected flow value at the input end of the fluid channel. The second control unit 9 is configured, when the detected flow value exceeds a preset flow range, to control a pumping speed of the fluid pump 3 until the detected flow value falls within the preset flow range.

By means of the flow detection unit 7 and the second control unit 9, the pumping speed of the fluid pump 3 may be calculated according to the detected flow value using an appropriate closed-loop control algorithm (for example, a PID control algorithm), thereby enabling the detected flow value to be controlled within the preset flow range and ensuring that the flow rate of the fluid in the fluid channel remains stable.

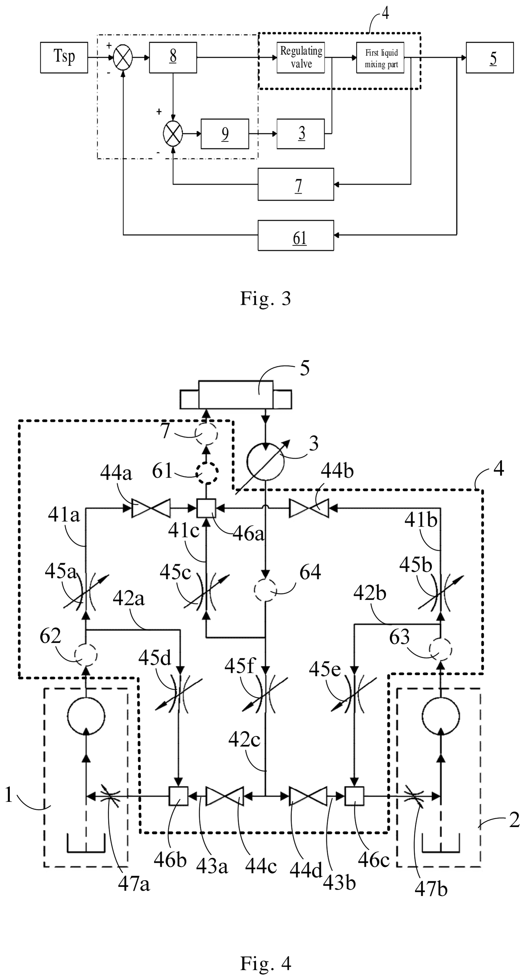

Referring to FIG. 3, the second control unit 9 and the first control unit 8 may independently implement two closed-loop controls. Specifically, the first control unit 8 may implement closed-loop control of temperature and flow rate, and the second control unit 9 may implement closed-loop control of the pumping speed of the fluid pump 3 and flow rate.

In some embodiments, referring to FIG. 4, the fluid control unit 4 comprises: a first supply flow path 41a, a second supply flow path 41b, a third supply flow path 41c, a first return flow path 42a, a second return flow path 42b, a third return flow path 42c, a first return branch 43a, and a second return branch 43b.

One end of the first supply flow path 41a is connected to the output end of the first supply unit 1, and another end thereof is connected to the input end of the fluid channel. A first flow regulating valve 45a and a first on-off valve 44a are disposed on the first supply flow path 41a.

One end of the second supply flow path 41b is connected to the output end of the second supply unit 2, and another end thereof is connected to the input end of the fluid channel. A second flow regulating valve 45b and a second on-off valve 44b are disposed on the second supply flow path 41b.

One end of the third supply flow path 41c is connected to the output end of the fluid pump 3, and another end thereof is connected to the input end of the fluid channel. A third flow regulating valve 45c is disposed on the third supply flow path 41c.

One end of the first return flow path 42a is connected to the output end of the first supply unit 1, and another end thereof is connected to the input end of the first supply unit 1. A fourth flow regulating valve 45d is disposed on the first return flow path 42a.

One end of the second return flow path 42b is connected to the output end of the second supply unit 2, and another end thereof is connected to the input end of the second supply unit 2. A fifth flow regulating valve 45e is disposed on the second return flow path 42b.

One end of the third return flow path 42c is connected to the output end of the fluid pump 3, and another end thereof is respectively connected to one end of the first return branch 43a and one end of the second return branch 43b. A sixth flow regulating valve 45f is disposed on the third return flow path 42c.

Another end of the first return branch 43a and another end of the second return branch 43b are respectively connected to the input end of the first supply unit 1 and the input end of the second supply unit 2. A third on-off valve 44c and a fourth on-off valve 44d are respectively disposed on the first return branch 43a and the second return branch 43b.

The first on-off valve 44a through the fourth on-off valve 44d may, for example, be shut-off valves configured to open or close a corresponding flow path. When a flow path is open, fluid may pass through the shut-off valve; when the flow path is closed, fluid is blocked by the shut-off valve.

The first flow regulating valve 45a through the sixth flow regulating valve 45f may, for example, be servo valves configured to adjust an opening degree of a valve port in response to a control signal, thereby enabling adjustment of a flow rate of the fluid in the corresponding flow path.

When the first on-off valve 44a and the third on-off valve 44c are opened, and the second on-off valve 44b and the fourth on-off valve 44d are closed, the system may be switched to the cooling mode. In the cooling mode, the first flow ratio is adjusted by regulating the first flow regulating valve 45a and the fourth flow regulating valve 45d, and the second flow ratio is adjusted by regulating the third flow regulating valve 45c and the sixth flow regulating valve 45f.

When the second on-off valve 44b and the fourth on-off valve 44d are opened, and the first on-off valve 44a and the third on-off valve 44c are closed, the system may be switched to the heating mode. In the heating mode, the third flow ratio is adjusted by regulating the second flow regulating valve 45b and the fifth flow regulating valve 45e, and the fourth flow ratio is adjusted by regulating the third flow regulating valve 45c and the sixth flow regulating valve 45f.

When the first on-off valve 44a, the third on-off valve 44c, the second on-off valve 44b, and the fourth on-off valve 44d are all opened, the system may be switched to the constant temperature mode. In the constant temperature mode, the fifth flow ratio is adjusted by regulating the first flow regulating valve 45a and the fourth flow regulating valve 45d; the sixth flow ratio is adjusted by regulating the second flow regulating valve 45b and the fifth flow regulating valve 45e; and the seventh flow ratio is adjusted by regulating the third flow regulating valve 45c and the sixth flow regulating valve 45f.

Accordingly, switching among the cooling mode, the heating mode, and the constant temperature mode may be achieved.

In the cooling mode, the fluid output by the first supply unit 1 flows not only through the first flow regulating valve 45a, but also through the fourth flow regulating valve 45d. Similarly, the fluid output by the fluid pump 3 flows not only through the third flow regulating valve 45c, but also through the sixth flow regulating valve 45f.

Under this configuration, when an opening degree of the first flow regulating valve 45a changes, a flow resistance of the first supply flow path 41a in which it is disposed (that is, a ratio of a flow rate through the valve port to a pressure difference across the valve) changes accordingly. At this time, by adjusting an opening degree of the fourth flow regulating valve 45d, a flow resistance of the first return flow path 42a may be adjusted to vary in accordance with the change in the flow resistance of the first supply flow path 41a, thereby compensating for the change in flow resistance of the first return flow path 42a. The purpose is to maintain a constant flow resistance at the output end of the first supply unit 1, thereby avoiding adverse effects of pressure fluctuations on control accuracy.

When an opening degree of the third flow regulating valve 45c changes, a flow resistance of the third supply flow path 41c changes accordingly. At this time, by adjusting an opening degree of the sixth flow regulating valve 45f, a flow resistance of the third return flow path 42c may be adjusted to vary in accordance with the change in the flow resistance of the third supply flow path 41c, thereby compensating for the change in flow resistance of the third return flow path 42c. The purpose is to maintain a constant flow resistance at the output end of the fluid pump 3, thereby avoiding adverse effects of pressure fluctuations on control accuracy.

In the cooling mode, because the second on-off valve 44b and the fourth on-off valve 44d are in a closed state, the fluid output by the second supply unit 2 returns to the second supply unit 2 through the second return flow path 42b.

Similar to the cooling mode, in the heating mode, when an opening degree of the second flow regulating valve 45b changes, an opening degree of the fifth flow regulating valve 45e may be adjusted to regulate a flow resistance of the second return flow path 42b such that it varies in accordance with a change in flow resistance of the second supply flow path 41b, thereby compensating for the change in flow resistance of the second return flow path 42b. The purpose is to maintain a constant flow resistance at the output end of the second supply unit 2, thereby avoiding adverse effects of pressure fluctuations on control accuracy.

In the heating mode, because the first on-off valve 44a and the third on-off valve 44c are in a closed state, the fluid output by the first supply unit 1 returns to the first supply unit 1 through the first return flow path 42a.

In some embodiments, in order to avoid a situation in which, after a period of operation, the liquid levels of the fluids stored in the first supply unit 1 and the second supply unit 2 become inconsistent-where, in severe cases, the liquid level in one of the supply units may be insufficient to maintain normal operation of the equipment-in the constant temperature mode, when the fluid stored in the first supply unit 1 is lower than a first liquid level, the fourth on-off valve 44d is closed, and the third flow regulating valve 45c and the sixth flow regulating valve 45f are adjusted to split and deliver the fluid output by the fluid pump 3 to the first supply unit 1 and to the input end of the fluid channel.

When the fluid stored in the second supply unit 2 is lower than a second liquid level, the third on-off valve 44c is closed, and the third flow regulating valve 45c and the sixth flow regulating valve 45f are adjusted to split and deliver the fluid output by the fluid pump 3 to the second supply unit 2 and to the input end of the fluid channel.

That is, in the constant temperature mode, if the liquid level of the fluid stored in the first supply unit 1 is too low (i.e., lower than the first liquid level), the fourth on-off valve 44d is closed so that at least a portion of the fluid output by the fluid pump 3 is delivered to the first supply unit 1 and not to the second supply unit 2, thereby increasing the flow rate delivered to the first supply unit 1. If the liquid level of the fluid stored in the second supply unit 2 is too low (i.e., lower than the second liquid level), the third on-off valve 44c is closed so that at least a portion of the fluid output by the fluid pump 3 is delivered to the second supply unit 2 and not to the first supply unit 1, thereby increasing the flow rate delivered to the second supply unit 2. In this manner, the liquid level of the first supply unit 1 or the second supply unit 2 may be compensated, thereby maintaining normal operation of the equipment.

n some embodiments, in order to increase the fluid reserve of a corresponding supply unit prior to continuous temperature control (heating or cooling), so as to ensure that sufficient fluid is available to perform continuous heating or cooling control, in the constant temperature mode, prior to switching to the cooling mode, the fourth on-off valve 44d is closed, and the third flow regulating valve 45c and the sixth flow regulating valve 45f are adjusted to split and deliver the fluid output by the fluid pump 3 to the first supply unit 1 and to the input end of the fluid channel.

Prior to switching to the heating mode, the third on-off valve 44c is closed, and the third flow regulating valve 45c and the sixth flow regulating valve 45f are adjusted to split and deliver the fluid output by the fluid pump 3 to the second supply unit 2 and to the input end of the fluid channel.

That is, when it is necessary to enter the cooling mode and perform continuous cooling, the fourth on-off valve 44d may be closed so that at least a portion of the fluid output by the fluid pump 3 is delivered to the first supply unit 1 and not to the second supply unit 2, thereby increasing the fluid reserve delivered to the first supply unit 1. Similarly, when it is necessary to enter the heating mode and perform continuous heating, the third on-off valve 44c may be closed so that at least a portion of the fluid output by the fluid pump 3 is delivered to the second supply unit 2 and not to the first supply unit 1, thereby increasing the fluid reserve delivered to the second supply unit 2.

In some embodiments, the fluid control unit 4 further comprises a first liquid mixing part 46a, a second liquid mixing part 46b, and a third liquid mixing part 46c.

The first liquid mixing part 46a has one output end and three input ends. The output end of the first liquid mixing part 46a is connected to the input end of the fluid channel. The other end of the first supply flow path 41a, the other end of the second supply flow path 41b, and the other end of the third supply flow path 41c are respectively connected to the three input ends of the first liquid mixing part 46a.

The first liquid mixing part 46a is configured to fully mix fluid from at least one of the first supply flow path 41a, the second supply flow path 41b, and the third supply flow path 41c, to temporarily store the mixed fluid, and to output the mixed fluid to the fluid channel.

In some embodiments, another end of the first return flow path 42a is connected to the input end of the first supply unit 1, and another end of the first return branch 43a is connected to the first return flow path 42a at downstream of the fourth flow regulating valve 45d. The second liquid mixing part 46b is disposed on the first return flow path 42a and is located at a connection between the first return flow path 42a and the other end of the first return branch 43a.

The second liquid mixing part 46b is configured to fully mix fluid from at least one of the first return flow path 42a and the first return branch 43a, to temporarily store the mixed fluid, and to output the mixed fluid to the first supply unit 1.

Another end of the second return flow path 42b is connected to the input end of the second supply unit 2, and another end of the second return branch 43b is connected to the second return flow path 42b at downstream of the fifth flow regulating valve 45e. The third liquid mixing part 46c is disposed on the second return flow path 42b and is located at a connection between the second return flow path 42b and the other end of the second return branch 43b.

The third liquid mixing part 46c is configured to fully mix fluid from at least one of the second return flow path 42b and the second return branch 43b, to temporarily store the mixed fluid, and to output the mixed fluid to the second supply unit 2.

The first liquid mixing part 46a, the second liquid mixing part 46b, and the third liquid mixing part 46c may, for example, comprise a chamber or a pipeline structure.

In some embodiments, a seventh regulating valve 47a is disposed on the first return flow path 42a between the second liquid mixing part 46b and the input end of the first supply unit 1. An eighth regulating valve 47b is disposed on the second return flow path 42b between the third liquid mixing part 46c and the input end of the second supply unit 2.

The seventh regulating valve 47a and the eighth regulating valve 47b are configured to adjust a flow rate of fluid returned to the first supply unit 1 and the second supply unit 2, respectively. The seventh regulating valve 47a and the eighth regulating valve 47b may, for example, be manual regulating valves.

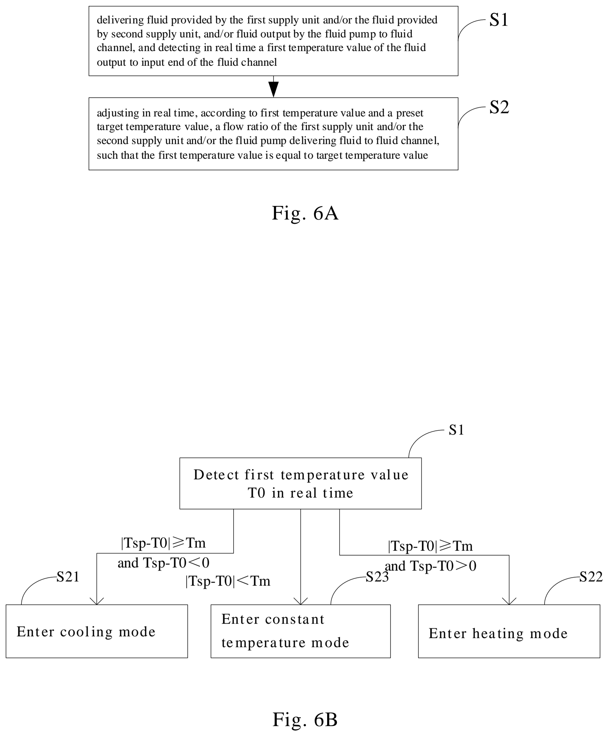

As another technical solution, referring to FIG. 6A, the embodiments of the present application further provide a temperature control method applied to the temperature control device described above. The method comprises:
S1: delivering the fluid provided by the first supply unit 1, and/or the fluid provided by the second supply unit 2, and/or the fluid output by the fluid pump 3 to the fluid channel, and detecting in real time a first temperature value of the fluid output to the input end of the fluid channel;
S2: adjusting in real time, according to the first temperature value and a preset target temperature value, a flow ratio of the first supply unit 1 and/or the second supply unit 2 and/or the fluid pump 3 delivering fluid to the fluid channel, such that the first temperature value is equal to the target temperature value.

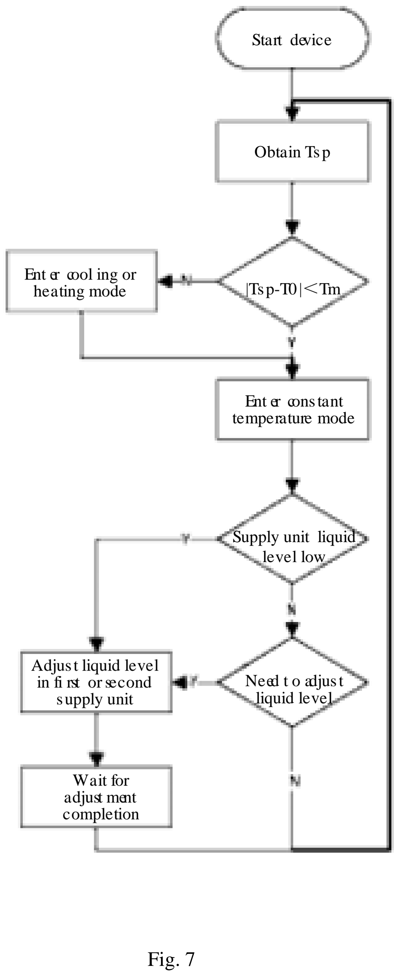

**In** some embodiments, as shown in FIGS. 6B and 7, step S2 specifically comprises:
**S21:** when an absolute value of a difference between the first temperature value T0 and a preset target temperature value Tsp is greater than or equal to a preset temperature threshold Tm, and the target temperature value Tsp is less than the first temperature value T0, entering the cooling mode; and in the cooling mode, splitting and delivering the fluid provided by the first supply unit 1 to the fluid channel and to the first supply unit 1, and splitting and delivering the fluid output by the fluid pump 3 to the first supply unit 1 and to the input end of the fluid channel;
**S22:** when the absolute value is greater than or equal to the preset temperature threshold Tm, and the target temperature value Tsp is greater than the first temperature value T0, entering the heating mode; and in the heating mode, splitting and delivering the fluid provided by the second supply unit 2 to the fluid channel and to the second supply unit 2, and splitting and delivering the fluid output by the fluid pump 3 to the second supply unit 2 and to the input end of the fluid channel;
**S23:** when the absolute value is less than the preset temperature threshold Tm, entering the constant temperature mode; and in the constant temperature mode, splitting and delivering the fluid provided by the first supply unit 1 to the fluid channel and to the first supply unit 1, splitting and delivering the fluid provided by the second supply unit 2 to the fluid channel and to the second supply unit 2, and splitting and delivering the fluid output by the fluid pump 3 to the first supply unit 1, the second supply unit 2, and the input end of the fluid channel.

**In** some embodiments, the temperature control method is applied to the temperature control device shown in FIG. 4. On this basis, the method further comprises:
opening the first on-off valve 44a and the third on-off valve 44c, and closing the second on-off valve 44b and the fourth on-off valve 44d to switch to the cooling mode; and in the cooling mode, adjusting the first flow ratio by regulating the first flow regulating valve 45a and the fourth flow regulating valve 45d, and adjusting the second flow ratio by regulating the third flow regulating valve 45c and the sixth flow regulating valve 45f;
wherein the first flow ratio, in the cooling mode, is defined as a ratio of a flow rate of the fluid provided by the first supply unit 1 delivered to the fluid channel to a flow rate of the fluid delivered to the first supply unit 1; and
the second flow ratio, in the cooling mode, is defined as a ratio of a flow rate of the fluid output by the fluid pump 3 delivered to the first supply unit 1 to a flow rate of the fluid delivered to the input end of the fluid channel;
opening the second on-off valve 44b and the fourth on-off valve 44d, and closing the first on-off valve 44a and the third on-off valve 44c to switch to the heating mode; and in the heating mode, adjusting the third flow ratio by regulating the second flow regulating valve 45b and the fifth flow regulating valve 45e, and adjusting the fourth flow ratio by regulating the third flow regulating valve 45c and the sixth flow regulating valve 45f;
wherein the third flow ratio, in the heating mode, is defined as a ratio of a flow rate of the fluid provided by the second supply unit 2 delivered to the fluid channel to a flow rate of the fluid delivered to the second supply unit 2; and
the fourth flow ratio, in the heating mode, is defined as a ratio of a flow rate of the fluid output by the fluid pump 3 delivered to the second supply unit 2 to a flow rate of the fluid delivered to the input end of the fluid channel.
opening the first on-off valve 44a, the third on-off valve 44c, the second on-off valve 44b, and the fourth on-off valve 44d to switch to the constant temperature mode; and in the constant temperature mode, adjusting the fifth flow ratio by regulating the first flow regulating valve 45a and the fourth flow regulating valve 45d, adjusting the sixth flow ratio by regulating the second flow regulating valve 45b and the fifth flow regulating valve 45e, and adjusting the seventh flow ratio by regulating the third flow regulating valve 45c and the sixth flow regulating valve 45f;
wherein the fifth flow ratio, in the constant temperature mode, is defined as a ratio of a flow rate of the fluid provided by the first supply unit 1 delivered to the fluid channel to a flow rate of the fluid delivered to the first supply unit 1;
the sixth flow ratio, in the constant temperature mode, is defined as a ratio of a flow rate of the fluid provided by the second supply unit 2 delivered to the fluid channel to a flow rate of the fluid delivered to the second supply unit 2; and
the seventh flow ratio, in the constant temperature mode, is defined as a ratio among a flow rate of the fluid output by the fluid pump 3 delivered to the first supply unit 1, a flow rate delivered to the second supply unit 2, and a flow rate delivered to the input end of the fluid channel.

In some embodiments, referring to FIG. 7, in the constant temperature mode, the method further comprises:
when the fluid stored in the first supply unit 1 is lower than a first liquid level, closing the fourth on-off valve 44d, and adjusting the third flow regulating valve 45c and the sixth flow regulating valve 45f to split and deliver the fluid output by the fluid pump 3 to the first supply unit 1 and to the input end of the fluid channel.
when the fluid stored in the second supply unit 2 is lower than a second liquid level, closing the third on-off valve 44c, and adjusting the third flow regulating valve 45c and the sixth flow regulating valve 45f to split and deliver the fluid output by the fluid pump 3 to the second supply unit 2 and to the input end of the fluid channel.

In some embodiments, referring to FIG. 7, in the constant temperature mode, the method further comprises:
prior to switching to the cooling mode, adjusting a liquid level by closing the fourth on-off valve 44d and adjusting the third flow regulating valve 45c and the sixth flow regulating valve 45f to split and deliver the fluid output by the fluid pump 3 to the first supply unit 1 and to the input end of the fluid channel;
and prior to switching to the heating mode, adjusting the liquid level by closing the third on-off valve 44c and adjusting the third flow regulating valve 45c and the sixth flow regulating valve 45f to split and deliver the fluid output by the fluid pump 3 to the second supply unit 2 and to the input end of the fluid channel.

In some embodiments, the method further comprises:
detecting in real time a detected flow value at the input end of the fluid channel; and
when the detected flow value exceeds a preset flow range, controlling a pumping speed of the fluid pump 3 until the detected flow value falls within the preset flow range.

Specifically, when the detected flow value exceeds the preset flow range, for example in the cooling mode, if the detected flow value is lower than the preset flow range, the pumping speed of the fluid pump 3 may be increased. In this case, a pressure difference between an input end and an output end of the fluid pump 3 increases, and a pressure at the input end of the third supply flow path 41c correspondingly increases. Because a response time of liquid pressure variation is shorter than a response time of the third flow regulating valve 45c, it may be considered that the third flow regulating valve 45c has not yet responded and its flow coefficient remains unchanged. As a result, a flow rate Q_{C} of fluid in the third supply flow path 41c increases as the pressure increases.

Meanwhile, a flow rate Q_{A} of fluid output from the first supply flow path 41a to the first liquid mixing part 46a remains unchanged because the output pressure of the first supply unit 1 remains constant and an opening degree of the first flow regulating valve 45a remains unchanged.

According to a relationship at the input end of the fluid channel, Q_{G} = Q_{A} + Qc, the total flow rate Q_{G} increases as Q_{C} increases. Accordingly, the detected flow value may be controlled within the preset flow range, thereby ensuring that the flow rate of the fluid in the fluid channel remains stable.

For the method embodiments, because they are substantially similar to the device embodiments, the description is relatively concise. For related aspects, reference may be made to the corresponding description of the device embodiments.

As another technical solution, the embodiments of the present application further provide semiconductor process equipment, comprising a process chamber and a pedestal disposed in the process chamber. The pedestal is configured to support a wafer, and a fluid channel configured to control a temperature of the wafer is disposed in the pedestal. The semiconductor process equipment further comprises the temperature control device provided in the embodiments of the present application, configured to control a temperature of fluid in the fluid channel.

The semiconductor process equipment provided in the embodiments of the present application, by adopting the temperature control device described above, can improve both the heating rate and the cooling rate of an electrostatic chuck.

It should be understood that the foregoing embodiments are merely exemplary embodiments provided for the purpose of explaining the principles of the present application, and the present application is not limited thereto. For those skilled in the art, various modifications and improvements may be made without departing from the spirit and essence of the present application, and such modifications and improvements shall also fall within the scope of protection of the present application.

## Claims

1. A temperature control device, applied to semiconductor process equipment, comprising:
a first supply unit configured to provide a fluid at a first temperature;
a second supply unit configured to provide a fluid at a second temperature, wherein the second temperature is higher than the first temperature;
a fluid pump connected to an output end of a fluid channel in a controlled component of the semiconductor process equipment and configured to extract fluid from the fluid channel; and
a fluid control unit connected to the first supply unit, the second supply unit, the fluid pump, and an input end of the fluid channel, and configured to:
deliver the fluid provided by the first supply unit and/or the fluid provided by the second supply unit and/or the fluid output by the fluid pump to the fluid channel,
detect in real time a first temperature value of the fluid output by the fluid control unit to the input end of the fluid channel, and
adjust in real time, according to the first temperature value and a preset target temperature value, a flow ratio of the first supply unit, and/or the second supply unit, and/or the fluid pump delivering fluid to the fluid channel, such that the first temperature value is equal to the target temperature value.

2. The temperature control device according to claim 1, wherein the fluid control unit is configured to switch among a cooling mode, a heating mode, and a constant temperature mode;
in the cooling mode, the fluid control unit is configured to split and deliver the fluid provided by the first supply unit to the fluid channel and to the first supply unit, and to split and deliver the fluid output by the fluid pump to the first supply unit and to the input end of the fluid channel;
in the heating mode, the fluid control unit is configured to split and deliver the fluid provided by the second supply unit to the fluid channel and to the second supply unit, and to split and deliver the fluid output by the fluid pump to the second supply unit and to the input end of the fluid channel; and
in the constant temperature mode, the fluid control unit is configured to split and deliver the fluid provided by the first supply unit to the fluid channel and to the first supply unit, to split and deliver the fluid provided by the second supply unit to the fluid channel and to the second supply unit, and to split and deliver the fluid output by the fluid pump to the first supply unit, the second supply unit, and the input end of the fluid channel.

3. The temperature control device according to claim 2, wherein, in the constant temperature mode, the fluid control unit is further configured to:
when the fluid stored in the first supply unit is lower than a first liquid level, split and deliver the fluid output by the fluid pump to the first supply unit and to the input end of the fluid channel; or
when the fluid stored in the second supply unit is lower than a second liquid level, split and deliver the fluid output by the fluid pump to the second supply unit and to the input end of the fluid channel.

4. The temperature control device according to claim 2, wherein, in the constant temperature mode, the fluid control unit is further configured:
prior to switching to the cooling mode, to split and deliver the fluid output by the fluid pump to the first supply unit and to the input end of the fluid channel; or
prior to switching to the heating mode, to split and deliver the fluid output by the fluid pump to the second supply unit and to the input end of the fluid channel.

5. The temperature control device according to claim 2, wherein the fluid control unit comprises:
a first temperature sensor configured to detect the first temperature value in real time; and
a first control unit configured to:
enter the cooling mode when an absolute value of a difference between the first temperature value and the target temperature value is greater than or equal to a preset temperature threshold and the target temperature value is less than the first temperature value; or
enter the heating mode when the absolute value is greater than or equal to the preset temperature threshold and the target temperature value is greater than the first temperature value; or
enter the constant temperature mode when the absolute value is less than the preset temperature threshold.

6. The temperature control device according to claim 5, wherein the fluid control unit further comprises:
a second temperature sensor configured to detect in real time a second temperature value at an output end of the first supply unit;
a third temperature sensor configured to detect in real time a third temperature value at an output end of the second supply unit;
a fourth temperature sensor configured to detect in real time a fourth temperature value at an output end of the fluid pump;
wherein the first control unit is further configured to:
in the cooling mode, adjust in real time a flow ratio of the first supply unit and the fluid pump delivering fluid to the fluid channel according to the first temperature value, the second temperature value, the third temperature value, the fourth temperature value, and the target temperature value; or
in the heating mode, adjust in real time a flow ratio of the second supply unit and the fluid pump delivering fluid to the fluid channel according to the first temperature value, the second temperature value, the third temperature value, the fourth temperature value, and the target temperature value; or
in the constant temperature mode, adjust in real time a flow ratio of the first supply unit, the second supply unit, and the fluid pump delivering fluid to the fluid channel according to the first temperature value, the second temperature value, the third temperature value, the fourth temperature value, and the target temperature value.

7. The temperature control device according to any one of claims 1-6, wherein the fluid control unit further comprises:
a flow detection unit configured to detect in real time a detected flow value at the input end of the fluid channel; and
a second control unit configured, when the detected flow value exceeds a preset flow range, to control a pumping speed of the fluid pump until the detected flow value falls within the preset flow range.

8. The temperature control device according to any one of claims 1-6, wherein the fluid control unit comprises:
a first supply flow path having one end connected to the output end of the first supply unit and another end connected to the input end of the fluid channel, wherein a first flow regulating valve and a first on-off valve are disposed on the first supply flow path;
a second supply flow path having one end connected to the output end of the second supply unit and another end connected to the input end of the fluid channel, wherein a second flow regulating valve and a second on-off valve are disposed on the second supply flow path;
a third supply flow path having one end connected to the output end of the fluid pump and another end connected to the input end of the fluid channel, wherein a third flow regulating valve is disposed on the third supply flow path;
a first return flow path having one end connected to the output end of the first supply unit and another end connected to the input end of the first supply unit, wherein a fourth flow regulating valve is disposed on the first return flow path;
a second return flow path having one end connected to the output end of the second supply unit and another end connected to the input end of the second supply unit, wherein a fifth flow regulating valve is disposed on the second return flow path; and
a third return flow path, a first return branch, and a second return branch, wherein one end of the third return flow path is connected to the output end of the fluid pump and another end is respectively connected to one end of the first return branch and one end of the second return branch,
wherein a sixth flow regulating valve is disposed on the third return flow path, wherein another end of the first return branch and another end of the second return branch are respectively connected to the input end of the first supply unit and the input end of the second supply unit, and
wherein a third on-off valve and a fourth on-off valve are respectively disposed on the first return branch and the second return branch.

9. The temperature control device according to claim 8, wherein the fluid control unit further comprises a first liquid mixing part, a second liquid mixing part, and a third liquid mixing part, wherein:
the first liquid mixing part has one output end and three input ends, the output end of the first liquid mixing part being connected to the input end of the fluid channel, and the another of the first supply flow path, the another end of the second supply flow path, and the another end of the third supply flow path being respectively connected to the three input ends of the first liquid mixing part;
the another end of the first return branch is connected to the first return flow path at downstream of the fourth flow regulating valve, and the second liquid mixing part is disposed on the first return flow path at a connection between the first return flow path and the another end of the first return branch; and
the another end of the second return branch is connected to the second return flow path at downstream of the fifth flow regulating valve, and the third liquid mixing part is disposed on the second return flow path at a connection between the second return flow path and the another end of the second return branch.

10. The temperature control device according to claim 9, wherein:
a seventh regulating valve is disposed on the first return flow path between the second liquid mixing part and the input end of the first supply unit; and
an eighth regulating valve is disposed on the second return flow path between the third liquid mixing part and the input end of the second supply unit.

11. A temperature control method, applied to the temperature control device according to any one of claims 1-10, the method comprising:
delivering the fluid provided by the first supply unit and/or the fluid provided by the second supply unit and/or the fluid output by the fluid pump to the fluid channel, and detecting in real time a first temperature value of the fluid output to the input end of the fluid channel; and
adjusting in real time, according to the first temperature value and a preset target temperature value, a flow ratio of the first supply unit and/or the second supply unit and/or the fluid pump delivering fluid to the fluid channel, such that the first temperature value is equal to the target temperature value.

12. The temperature control method according to claim 11, wherein the adjusting in real time, according to the first temperature value and the preset target temperature value, the flow ratio of the first supply unit and/or the second supply unit and/or the fluid pump delivering fluid to the fluid channel, such that the first temperature value is equal to the target temperature value, comprises:
when an absolute value of a difference between the first temperature value and the target temperature value is greater than a preset temperature threshold, and the target temperature value is less than the first temperature value, entering a cooling mode, and in the cooling mode, splitting and delivering the fluid provided by the first supply unit to the fluid channel and to the first supply unit, and splitting and delivering the fluid output by the fluid pump to the first supply unit and to the input end of the fluid channel;
when the absolute value of the difference is greater than the preset temperature threshold, and the target temperature value is greater than the first temperature value, entering a heating mode, and in the heating mode, splitting and delivering the fluid provided by the second supply unit to the fluid channel and to the second supply unit, and splitting and delivering the fluid output by the fluid pump to the second supply unit and to the input end of the fluid channel; and
when the absolute value is less than or equal to the preset temperature threshold, entering a constant temperature mode, and in the constant temperature mode, splitting and delivering the fluid provided by the first supply unit to the fluid channel and to the first supply unit, splitting and delivering the fluid provided by the second supply unit to the fluid channel and to the second supply unit, and splitting and delivering the fluid output by the fluid pump to the first supply unit, the second supply unit, and the input end of the fluid channel.

13. The temperature control method according to claim 11, further comprising:
detecting in real time a detected flow value at the input end of the fluid channel; and when the detected flow value exceeds a preset flow range, controlling a pumping speed of the fluid pump until the detected flow value falls within the preset flow range.

14. Semiconductor process equipment, comprising:
a process chamber;
a pedestal disposed in the process chamber and configured to support a wafer, wherein a fluid channel configured to control a temperature of the wafer is disposed in the pedestal; and
the temperature control device according to any one of claims 1-10, configured to control a temperature of fluid in the fluid channel.
